# EUROPÄISCHE PATENTANMELDUNG

(11) **EP 2 736 075 A2**
(43) Veröffentlichungstag der Anmeldung: **28.05.2014**
(21) Anmeldenummer: 13192409.4
(22) Anmeldetag: 12.11.2013
(51) Int. Cl.: H01L 27/30, H01L 51/00, H01L 51/42, H01L 31/0749

(54) **Tandem-Dünnschicht-Solarzelle**

(30) Priorität: 21.11.2012 DE 102012022745
(71) Anmelder: Helmholtz-Zentrum Berlin für Materialien und Energie GmbH, 14109 Berlin (DE)
(72) Erfinder: Rusu, Marin, 13589 Berlin (MD); Lux-Steiner, Martha Christina, 14163 Berlin (CH); Wiesner, Sven, 14478 Potsdam (DE); Hinrichs, Volker, 14167 Berlin (DE)

(57) **Zusammenfassung**

Die Erfindung betrifft eine Tandem-Dünnschicht-Solarzelle, die mindestens aus zwei Subzellen besteht, wobei das Absorbermaterial der rückseitigen Zelle anorganisch oder organisch ist und breitbandig absorbiert und das organische Absorbermaterial der Frontzelle in einem Bereich des Spektrums schmalbandig absorbiert, wobei dieser Bereich gegenüber dem Bereich des Spektrums, in dem das Absorbermaterial der rückseitigen Zelle absorbiert, bei längeren Wellenlängen liegt.

## Beschreibung

Die Erfindung betrifft eine Tandem-Dünnschicht-Solarzelle, aufweisend eine als Frontzelle ausgebildete Subzelle mit organischem Absorbermaterial und eine als rückseitige Zelle ausgebildete Subzelle, die zwischen einer auf der Frontzelle angeordneten Frontelektrode und einer auf der rückseitigen Zelle benachbarten Rückseitenelektrode, die auf einem Substrat angeordnet ist, angeordnet sind.

### Stand der Technik

Eine Tandem-Solarzelle (englisch: multi-junction solar cell) besteht aus zwei oder mehr Solarzellen, auch Subzellen genannt, die aus Materialen bestehen, die in unterschiedlichen Wellenlängenbereichen des Sonnenspektrums Licht absorbieren. Die Absorption von Photonen in geeigneten Absorbermaterialien wird in Solarzellen zur Generierung eines Photostroms genutzt. Der Wirkungsgrad der gesamten Anordnung kann durch die einander ergänzende Absorption der Absorbermaterialien in den Subzellen optimiert werden. Es wird somit ein breiterer Teil des Spektrums des Sonnenlichtes genutzt als mit einer Einzelzelle.

Im **Aufsatz 1** von S. Sista et al. (Tandem polymer photovoltaic cells - current status, challenges and future outlook, Energy & Environmental Science 2001, Vol 4, S. 1606-1620) und im **Aufsatz 2** von T. M. Razykov (Solar photovoltaic electricity: Current status and future prospects, Solar Energy 2011, Vol. 85, S. 1580-1608) wird ein Überblick über Materialien, Herstellung, erreichte Effizienzen für Tandem-Solarzellen und theoretische Grundlagen der Tandem-Solarzellen gegeben.

Tandem-Solarzellen sind optisch und elektrisch in Reihe geschaltet (Englisch: series circuit; dem Englischen folgend im Deutschen oft synonym als in Serie geschaltet bezeichnet). Durch die Verschaltung in Reihe kommt es zu einer Addition der Leerlaufspannung (open circuit voltage) der Subzellen. Zusätzlich bestimmt, vereinfacht dargestellt, der kleinste der Kurzschlussströme (short circuit current) der Subzellen den Gesamtkurzschlussstrom. Daraus folgt die Forderung nach der Stromanpassung der einzelnen Subzellen, um Verluste zu minimieren. Die Kurzschlussströme sind proportional der Gesamtzahl der absorbierten Photonen, die wiederum abhängig ist von der Dicke der Absorberschichten und den Absorptionskoeffizienten der Absorbermaterialien. Die Effizienz bzw. der Wirkungsgrad von Solarzellen wird wesentlich bestimmt durch die Größe des Kurzschlussstroms und der Leerlaufspannung.

Das Konzept der Tandem-Solarzelle lässt sich auch in Dünnschichttechnologie umsetzen.

Beim Einsatz von Halbleitermaterialien in Tandem-Solarzellen ist zu berücksichtigen, dass alle Photonen mit einer Energie, die größer ist als die Energie der Bandlücke, absorbiert werden. Ein Halbleitermaterial auf der lichtzugewandten Seite, d.h. der Front der Solarzelle, muss demnach eine größere Bandlücke aufweisen als das nachfolgende, rückseitige Absorbermaterial. Das rückseitige Absorbermaterial muss entsprechend eine kleinere Bandlücke aufweisen. Dieser Umstand ist der hauptsächliche Grund für die konventionelle Anordnung der Absorbermaterialien, die von der Front zur Rückseite der Solarzelle abnehmende Energien der Bandlücken aufweisen.

Die Bandlücke in einem Halbleitermaterial ist bestimmt durch den Abstand des Valenzbandes zum Leitungsband. Ein Halbleiter, der eine kleine Bandlücke aufweist, absorbiert Photonen im langwelligen Bereich des Spektrums. Ein Halbleiter mit einer großen Bandlücke absorbiert Photonen im kurzwelligen Bereich des Spektrums. Das Äquivalent zur Bandlücke der Halbleiter in organischen Absorbermaterialien (Energielücke) ergibt sich aus der Differenz zwischen dem Energieniveau des niedrigsten unbesetzten Molekülorbital (LUMO: lowest unoccupied molecular orbital) des Akzeptormaterials und dem Energielevel des höchsten besetzten Molekülorbital (HOMO: highest occupied molecular orbital) des Donatormaterials.

Die Absorption sowohl im langwelligen als auch im kurzwelligen Bereich kann breitbandig sein. Das bedeutet, dass Photonen in einem Wellenlängenbereich des Spektrums mit einer Breite größer als 300 nm absorbiert werden. Dies ist zum Beispiel für halbleitende Absorbermaterialien der Fall, die alle Photonen mit einer Energie größer der ihrer Bandlücke absorbieren. Die Absorption kann aber auch schmalbandig sein, so dass Photonen in einem nach oben oberhalb der Bandlücke, begrenzten, schmalen Bereich des Spektrums absorbiert werden.

Absorbierte Photonen mit Energien, die größer sind als die der Bandlücke, verursachen in Materialien mit breitbandigem Absorptionsverhalten Verluste durch Relaxationen. Dabei wird bei dem größten Teil der Relaxationen thermische Energie an das Material abgeben. Die auftretende Erwärmung ist unerwünscht, da die Leitfähigkeit der Materialien hiervon stark negativ beeinflusst wird. Dies ist ein weiterer Grund für die konventionelle Anordnung der Absorbermaterialien, die von der Front zur Rückseite mit abnehmender Energie der Bandlücke angeordnet sind, da so Thermalisierungsverluste reduziert werden können.

Deshalb wird in dem bereits erwähnten **Aufsatz 1** die Forderung nach einem konventionellen Aufbau von Tandem-Solarzellen zur Reduktion von Thermalisierungsverlusten formuliert.

Weitere Verluste in Tandem-Solarzellen resultieren aus der begrenzten Transmission der Subzellen. Die jeweils zuvorderst vom Licht durchstrahlte Subzelle schwächt das Licht durch verschiedene Prozesse im Absorptionsbereich der nachfolgenden Subzelle oder Subzellen.

Rekombinationsschichten zwischen den Subzellen können für eine gute elektrische Verbindung zwischen den beiden Subzellen sorgen. Eine effiziente Rekombination der Löcher aus der einen Subzelle mit den Elektronen aus der anderen Subzelle in der Rekombinationsschicht bewirkt, dass die beiden Subzellen elektrisch in Reihe (Serie) geschaltet sind.

Eine Elektronenleit- oder Löcherleitschicht in einem monolithischen Tandem-Solarzellenaufbau wirkt als Transportschicht, die nur die gewünschte Ladungsträgerart durchlässt und die andere Ladung an dieser Schicht zurückreflektiert. Sie wirkt demnach als Blockade für die andere Ladung, d.h. sie wirkt wie eine semipermeable Membran.

Fensterschichten in Solarzellen bestehen aus transparenten Materialien und verhindern, dass sogenannte Minoritätsladungsträger bereits vor dem Erreichen eines Grenzflächenübergangs bzw. im aktiven Halbleitermaterial rekombinieren. Dies wird durch ein hohes elektrisches Feld, erzeugt durch eine höhere Dotierung und Bandlücke der Materialien der Fensterschichten, erreicht.

Zusätzlich zu den Fensterschichten werden, besonders in Solarzellen mit Absorbermaterialien aus Kupferchalkogenid, Pufferschichten zwischen dem Übergang vom Absorbermaterial zu den Fensterschichten eingefügt. Die Pufferschicht dient zur Gitteranpassung am Übergang Absorbermaterial-Fensterschicht und reduziert die Rekombinationsraten von Elektronen-Lochpaaren.

Entscheidend für die Schichtfolge in der Tandem-Solarzelle ist auch das Herstellungsverfahren. Da die verschiedenen Schichten der Subzellen nacheinander aufgebracht werden, muss die jeweils früher aufgebrachte Schicht die Prozessierung der späteren Schichten überstehen. Dies ist besonders für die organischen Materialien von Belang, die sehr empfindlich auf hohe Temperaturen reagieren.

In WO 2012/018237 ist eine Tandem-Solarzelle offenbart, die aus einer Subzelle mit einem anorganischen Absorbermaterial als Frontzelle und einer Subzelle mit einem organischen Absorbermaterial als rückseitige Zelle besteht. Das benannte anorganische Absorbermaterial, a-Si:H, absorbiert breitbandig im kurzwelligen Bereich. Das organische Absorbermaterial, das benannt wird, PCPDTBT:PC70BM, absorbiert im langwelligen Bereich des Spektrums und weist ebenfalls eine breitbandige Absorption auf. Bei dieser Anordnung wirkt sich das unzureichend aufeinander abgestimmte Absorptionsverhalten der beiden Subzellen wegen der auftretenden Transmissionsverluste negativ auf die gesamt Effizienz der Tandem-Solarzelle aus.

In US 7,166,366 B2 ist eine Tandem-Solarzelle offenbart, die sich aus zwei Subzellen aus organischem Material zusammensetzt. Dabei bestehen in beiden Subzellen die Absorbermaterialien aus einem Gemisch von CuPc (Kupferphthalocyanin) und C₆₀. Lediglich die Zusammensetzung variiert in diesem Gemisch, wodurch die Absorption und die Effizienz der Subzellen in verschiedenen Banden, im langwelligen und kurzwelligen Bereich, unterschiedlich stark ausgeprägt sind. Die Absorption ist für beide Subzellen breitbandig und die Bereiche, in denen absorbiert wird, überlappen sich komplett. Auch in dieser Anordnung wirkt sich die schlecht aufeinander abgestimmte Absorption und Transmission der Subzellen negativ auf die Effizienz der Tandem-Solarzelle aus.

In WO 2011/118890 A1, die den nächstliegenden Stand der Technik bildet, ist eine Tandem-Solarzelle offenbart, die aus einer Subzelle mit einem organischen Absorbermaterial, als Frontzelle, und einer Subzelle mit einem anorganischen Absorbermaterial, als rückseitige Zelle, besteht. Die benannten organischen Absorbermaterialien absorbieren im kurzwelligen Bereich des Spektrums und weisen eine schmal- bis breitbandige Absorption auf. Die benannten anorganischen Absorbermaterialien absorbieren breitbandig im langwelligen Bereich. Der Nachteil dieser Anordnung liegt in der Schwierigkeit einer guten Stromanpassung zwischen den beiden Stapelzellen, da organische Solarzellen mit großer Bandlücke sehr geringe Photoströme aufweisen, und die Effizienz der Tandem-Solarzelle dadurch verringert wird.

### Aufgabenstellung

Ausgehend von den Nachteilen des bekannten Standes der Technik ist die Aufgabe für die vorliegende Erfindung darin zu sehen, eine Tandem-Dünnschicht-Solarzelle anzugeben, bei der Transmissionsverluste verringert sind und somit ihre Effizienz verbessert wird.

Die Aufgabe wird durch die Merkmale des Anspruchs 1 gelöst. Dabei weist die Tandem-Dünnschicht-Solarzelle der eingangs genannten Art erfindungsgemäß ein organisches Absorbermaterial in der Frontzelle auf, das im langwelligen Bereich des Spektrums schmalbandig absorbiert und sich dadurch nicht oder nur geringfügig mit dem Absorptionsintervall der rückseitigen Zelle überschneidet. Das anorganische oder organische Absorbermaterial der rückseitigen Zelle absorbiert im kurzwelligen Bereich ab der Bandlückenenergie breitbandig, zu kleineren Wellenlängen hin.

Durch den Einsatz eines schmalbandigen, im langwelligen Bereich absorbierenden, organischen Absorbermaterials in der Frontzelle, das im kurzwelligen Bereich hochtransparent ist, kann ein breitbandiges, im kurzwelligen Bereich absorbierendes, anorganisches Halbleitermaterial oder ein im kurzwelligen Bereich absorbierendes organisches Material für die rückseitige Subzelle zum Einsatz kommen.

Thermalisierungsverluste werden durch die hohe Transparenz des Absorbermaterials in der Frontzelle minimiert und die Effizienz dadurch insgesamt gesteigert.

Bezüglich der Absorptionseigenschaften der Frontzelle und der rückseitigen Zelle handelt es sich hier um eine Tandem-Solarzelle mit invertierter Absorption, d. h. invertiert in Bezug auf die dem Stand der Technik bekannte Anordnung.

Die Tandem-Dünnschicht-Solarzelle kommt im Falle einer idealen Anpassung der Absorbermaterialien in den Subzellen mit einer unteren und einer oberen Elektrode sowie einem Substrat aus.

Die Übergänge können frontseitig nach rückseitig erst n-, dann i-, dann p-leitend oder erst p-, dann i-, dann n-leitend gestaltet sein.

Ist die rückseitige Elektrode als Anode und die frontseitige Elektrode als Kathode ausgebildet, ist die Anordnung der Schichten, frontseitig nach rückseitig, vorgegeben. Die Frontzelle weist demnach eine erst n-, dann i-, dann p-leitende Schichtfolge des organischen Absorbermaterials auf. Die Übergänge in der rückseitigen Subzelle weisen entsprechend eine n-p- oder n-i-p- Folge auf. Diese Ausführung wird hier als NIP-Struktur bezeichnet.

Die Kathode der NIP-Struktur kann insbesondere aus Aluminium oder Mg:Ag, jeweils mit einer Schichtdicke kleiner als 10 nm, einem transparenten, elektrisch leitenden Oxid (transparent conductive oxide, TCO) mit einer Schichtdicke von 50 nm bis 1000 nm oder einer Mehrschichtelektrode nach DE 102009024935 A1 gebildet sein.

Die Mehrschichtelektrode, die in DE 102009024935 A1 offenbart ist, kombiniert Schichten aus Metallen oder Legierungen mit unterschiedlichen Austrittsarbeiten. Die Ausführungen können als Kathode oder Anode erfolgen. Das Absorbermaterial der Frontzelle der NIP-Struktur ist zum Beispiel als Gemisch (englisch blend) oder in Schichtfolgen organischer Materialien ausgebildet und weist eine Schichtdicke zwischen 20 nm bis 500 nm auf. Es weist entsprechend der erfindungsgemäßen Lösung eine Absorption im langwelligen Bereich oberhalb der Bandlücke der rückseitigen Zelle auf. Zudem ist eine hohe Ladungsträgerbeweglichkeit vorteilhaft.

Das anorganische Absorbermaterial der rückseitigen Zelle der NIP-Struktur ist insbesondere aus Chalkopyrit, Kesterit (Cu₂(Zn,Fe)SnS₄) CdTe, oder anderen II-VI-Halbleitern oder aus Silizium gebildet. Die rückseitige Zelle kann auch aus einem organischen Material gebildet werden, dessen Absorptionsbereich entsprechend der erfindungsgemäßen Lösung bei kürzeren Wellenlängen als denen der Frontzelle liegt.

Die Anode der NIP-Struktur weist eine Schichtdicke von 150 nm bis 1500 nm auf und ist aus Metall oder TCO gebildet.

In der NIP-Struktur ist in einer Ausführungsform eine Elektronenleitschicht, insbesondere bestehend aus BCP (Bathocuproine) oder Alq₃ (Aluminium-tris(8-hydroxychinolin)), die zwischen der Frontzelle und der Kathode ergänzend angeordnet.

Zusätzlich ist die NIP-Struktur in einer Ausführungsform durch eine Rekombinationsschicht mit einer Schichtdicke von 2 nm bis 20 nm, beispielsweise gebildet aus Silber Nanoclustern (Ag-NCs), die zwischen der Frontzelle und der rückseitigen Subzelle angeordnet ist, ergänzt.

Oberhalb der rückseitigen Subzelle oder oberhalb einer möglichen Rekombinationsschicht ist in der NIP-Struktur in einer Ausführungsform eine Löcherleitschicht angeordnet, die insbesondere aus einem Übergangsmetalloxid wie MoO₃, W₂O₃, V₂O₅ oder Polymeren, wie PEDOT:PSS (Poly(3,4-ethylenedioxythiophene):poly(styrenesulfonate)) oder PEDOT:DMAE (Poly(3,4-ethylenedioxythiophene):dimethylaminoethanol), besteht.

Ist die rückseitige Elektrode als Kathode und die frontseitige Elektrode als Anode ausgebildet, ist die Anordnung der Schichten, frontseitig nach rückseitig, ebenfalls vorgegeben. Die Schichten des organischen Absorbermaterials der Frontzelle weisen demnach eine Schichtfolge erst p-, dann i-, dann n-leitend und die Übergänge in der rückseitigen Subzelle eine p-n- oder p-i-n- Folge auf. Diese Ausführung wird hier als PIN-Struktur bezeichnet.

Die Anode ist in der PIN-Struktur insbesondere aus Aluminium oder Mg:Ag, jeweils mit einer Schichtdicke kleiner als 10 nm, aus TCO mit einer Schichtdicke von 50 nm bis 1000 nm oder einer Mehrschichtelektrode nach DE 10200924935 A1 gebildet.

Das Absorbermaterial der Frontzelle der PIN-Struktur ist zum Beispiel ein Gemisch oder eine Schichtfolge organischer Materialien und weist eine Schichtdicke zwischen 20 nm bis 500 nm auf.

Die rückseitige Subzelle der PIN-Struktur weist zum Beispiel die anorganischen Absorbermaterialen Chalkopyrit, CdTe, Kesterit (Cu₂(Zn,Fe)SnS₄) oder Silizium auf.

Die Kathode der PIN-Struktur weist eine Schichtdicke von 150 nm bis 1500 nm auf und ist aus einem Metall oder TCO gebildet.

Eine Löcherleitschicht, die zwischen der frontseitigen Subzelle und der Anode angeordnet ist und insbesondere aus einem Übergangsmetalloxid wie MoO₃, W₂O₃, V₂O₅ oder Polymeren, wie PEDOT:PSS (Poly(3,4-ethylenedioxythiophene):poly(styrenesulfonate)) oder PEDOT:DMAE besteht, ist in einer Ausführungsform ergänzend in die PIN-Struktur eingefügt.

Die PIN-Struktur ist in einer Ausführungsform zusätzlich durch eine zwischen der Frontzelle und der rückseitigen Subzelle angeordnete Rekombinationsschicht mit einer Schichtdicke von 2 nm bis 20 nm, insbesondere gebildet aus Silber-Nanoclustern (Ag-NCs), ergänzt.

Oberhalb der rückseitigen Subzelle oder oberhalb der erwähnten Rekombinationsschicht ist in einer Ausführungsform in der PIN-Struktur eine Elektronenleitschicht, insbesondere bestehend aus BCP (Bathocuproine) oder Alq₃ (Aluminium-tris(8-hydroxychinolin)), eingefügt.

Auf der frontseitigen Elektrode, sowohl der NIP als auch der PIN-Struktur, ist in einer Ausführungsform ein zusätzlicher metallischer dünner Gitterkontakt zur verbesserten Stromableitung angeordnet.

Die Schichtdicken werden je nach Anwendungsfall angepasst unter den Gesichtspunkten der steigenden Leitfähigkeit bei gleichzeitiger Verringerung der Transparenz mit zunehmender Schichtdicke.

In einer weiteren Ausführungsform ist auf ein Glassubstrat eine Anode aus einer 500 nm bis 1000 nm dicken Molybdänschicht aufgebracht, auf die eine rückseitige Subzelle, aufweisend eine Absorberschicht aus CuGaSe₂ mit einer Schichtdicke von 1 µm bis 2,5 µm, folgt. Diese ist von einer Pufferschicht aus CdS mit einer Schichtdicke von 10 nm bis 50 nm bedeckt. Darüber ist eine Fensterschicht aus i-ZnO mit einer Dicke von 30 nm bis 100 nm aufgebracht, gefolgt von einer weiteren Fensterschicht aus ZnO:Al mit einer Dicke von 10 nm bis 200 nm. Es folgt eine 3 nm bis 10 nm dicke Löcherleitschicht aus MoO₃, auf die das Absorbermaterial der Frontzelle aufgebracht ist. Dieses ist aufgebaut aus einer Schichtfolge, die, frontseitig nach rückseitig, aus einer 3 nm bis 40 nm dicken Schicht C₆₀, einer 50 nm bis 150 nm dicken Zn₃5Pc:C₆₀ Schicht und einer bis 2 nm bis 10 nm dicken Zn₃5Pc Schicht, besteht. Die Kathode auf der Frontseite ist aus einer Schicht Mg:Ag mit einer Dicke kleiner als 10 nm gebildet und ist von einer 50 nm bis 300 nm dicken Schicht ZnO:Al bedeckt. Ein Kontaktgitter aus Ni/Al oder Ag beschließt die Schichtfolge der Tandem-Solarzelle auf der Frontseite.

### Ausführungsbeispiel

Die Erfindung soll in folgendem Ausführungsbeispiel anhand von Zeichnungen näher erläutert werden.

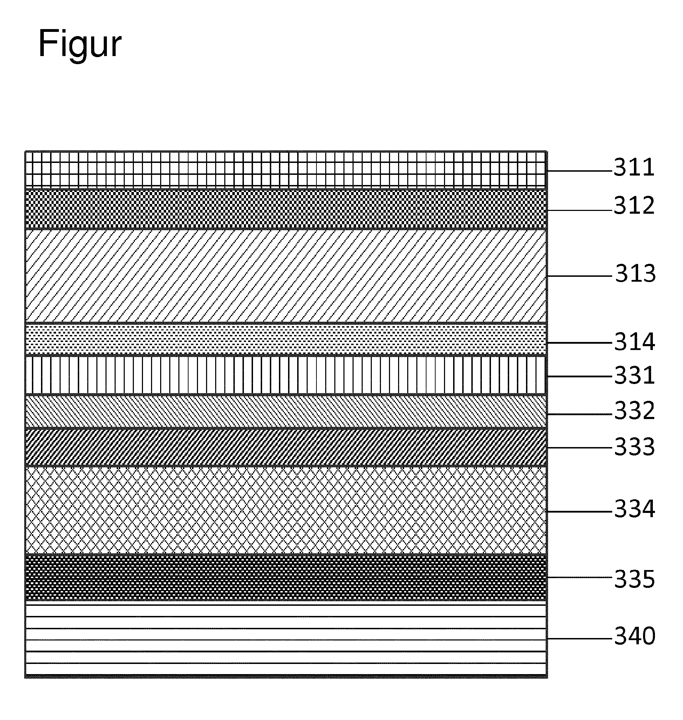

Die Figur hierzu zeigt schematisch eine Schichtfolge in einer erfindungsgemäßen Tandem-Dünnschicht-Solarzelle mit invertierter Absorption.

Das Substrat **340** ist aus Glas. Auf das Substrat ist die rückseitig liegende Elektrode, die als Anode **335** ausgebildet ist, aufgebracht. Sie besteht aus einer 500 nm bis 1000 nm dicken Molybdänschicht. Auf die Anode **335** ist die rückseitige Subzelle aufgebracht, die eine Absorberschicht **334** aus CuGaSe₂ aufweist.

Das Aufbringen der Absorberschicht **334** aus CuGaSe₂ erfolgt vorteilhaft durch die CCSVT-Technik (chemical close-spaced vapor transport; chemischer Gasphasentransport im geschlossenen Raum), die in dem **Aufsatz 3** von M. Rusu et al. (CuGaSe2 thin films prepared by a novel CCSVT technique for photovoltaic application, Thin Solid Films 451 -452 (2004) 556-561) detailliert dargestellt ist.

Bei dieser Technik wird zunächst ein Cu-Präkursor konventionell auf die Anode aufgebracht. Danach wird der Prekursor thermisch und chemisch in einer gasförmigen GaClₓ/H₂Se-Atmosphäre in einem CCSVT-Ofen behandelt. Der CCSVT-Ofen ermöglicht die Zuführung der gasförmigen GaClₓ/H₂Se-Atmosphäre und wird durch Infrarotstrahlung bis zu Temperaturen um die 520 °C beheizt. Die Wachstumsrate der CuGaSe₂-Schicht **334** beträgt bis zu 240 nm/min.

Die Absorption einer so hergestellten CuGaSe₂-Schicht **334** ist ebenfalls in dem **Aufsatz 3** indirekt über die externe Quanteneffizienz dargestellt. Sie ist breitbandig und umfasst den kurzwelligen Bereich von 375 nm bis 740 nm.

Auf die CuGaSe₂-Absorberschicht **334** wird in konventioneller Weise anschließend eine Pufferschicht **333** aus CdS mit einer Schichtdicke von 40 nm, dann eine 90 nm dicke Fensterschicht **332** aus i-ZnO und anschließend eine 300 nm dicke Fensterschicht **331** aus ZnO:Al. Die CdS-Schicht bildet den p-n Übergang mit der CuGaSe₂-Absorberschicht.

Auf die CuGaSe₂-Absorberschicht wird dann eine 4 nm dicke Löcherleitschicht **314** aus MoO₃ durch thermisches Aufdampfen im Vakuum aufgebracht.

Das Absorbermaterial der Frontzelle **313** ist aus einer Schichtfolge von Fulleren C₆₀, Phthalocyaninkomplexen und einer Schicht aus einem Gemisch von Fulleren und Phthalocyaninkomplexen- gebildet.

Die Präparation und der Aufbau des hier eingesetzten Phthalocyaninkomplexes ist in dem **Aufsatz 4** von S. G. Makarov et al. (Linear and Rectangular Trinuclear Phthalocyanines, European Journal of Inorganic. Chemistry 2007, 546-552) beschrieben. Es handelt sich um ein Phthalocyanintrimer, das mit drei Zink legiert ist. Der Aufbau des Trimers ist linear. Der Nomenklatur der Autoren nach wird der Komplex als Zn₃5Pc bezeichnet.

Das Absorptionsverhalten des Phthalocyaninkomplexes ist in dem **Aufsatz 4** in Form des Verlaufs des Extinktionskoeffizienten wiedergegeben. Zn₃5Pc absorbiert schmalbandig im langwelligen Bereich zwischen 900 nm und 1000 nm und ist ansonsten hochtransparent.

Die Mischung des Zn₃5Pc mit C₆₀ bewirkt durch die Vermischung des Donators mit dem Akzeptor kürzere Diffusionswege für die Excitonen. Dadurch sind höhere Schichtdicken und somit stärkere Absorption möglich.

Die Schichtfolge des Absorbermaterials der Frontzelle **313** entspricht, frontseitig nach rückseitig, einer C₆₀-Schicht von 10 nm Dicke, gefolgt von einer 80 nm dicken Schicht Zn₃5Pc:C₆₀ und einer Zn₃5Pc-Schicht mit einer Dicke von 5 nm.

Das organische Material kann aufgebracht werden durch thermisches Aufdampfen (Physical Vapor Deposition, PVD), organische Gasphasenabscheidung (Organic Vapor Phase Deposition, OVPD) oder nasschemisch durch Abscheidung aus Lösungen oder Dispersionen.

Auf die Frontzelle wird die Kathode **312** aufgebracht. Sie besteht aus einer Mg:Ag-Schicht mit einer Schichtdicke von 8 nm und einer ZnO:Al-Schicht mit einer Schichtdicke von 200 nm, die durch Kathodenzerstäubung aufgebracht wird.

Die Mg:Ag-Legierung, die hier zum Einsatz kommt, ist ausführlich in dem **Aufsatz 5** von M. Rusu et al. (Formation of charge-selective Mg-Ag electrodes to CuPc:C60 blend layers, Applied Physics Letters 97, 073504, 2010) beschrieben. Sie ist optimiert für den Einsatz als Kathodenmaterial einer Solarzelle, die einen organischen Absorber aus einem Gemisch von einem Cu-Phtalocyaninkomplex mit C₆₀ umfasst. Das Mischungsverhältnis in der Legierung ist nahe Ag₃Mg. Durch den Einsatz dieses Kathodenmaterials ist eine Pufferschicht über der Zelle aus organischem Material überflüssig. Die ZnO:Al-Kathode wird mittels Kathodenzerstäubung aufgebracht, wie es im **Aufsatz 3** beschrieben ist.

Ein Kontaktgitter **311** aus Ni/Al oder Ag schließt die Tandem-Solarzelle auf der Frontseite ab. Das Gitter dient der verbesserten Ladungssammlung und wird mit Hilfe einer Maske im Vakuum aufgedampft.

## Patentansprüche

1. Tandem-Dünnschicht-Solarzelle mindestens aufweisend eine als Frontzelle ausgebildete Subzelle mit organischem Absorbermaterial und eine als rückseitige Zelle ausgebildete Subzelle, die zwischen einer auf der Frontzelle angeordneten Frontelektrode und einer auf der rückseitigen Zelle benachbarten Rückseitenelektrode, die auf einem Substrat angeordnet ist, angeordnet sind,
**dadurch gekennzeichnet, dass**
das Absorbermaterial der rückseitigen Zelle anorganisch oder organisch ist und breitbandig im kurzwelligen Bereich des Spektrums absorbiert und
das organische Absorbermaterial der Frontzelle im langwelligen Bereich des Spektrums schmalbandig absorbiert, wobei dieser Bereich gegenüber dem Bereich des Spektrums, in dem das Absorbermaterial der rückseitigen Zelle absorbiert, bei längeren Wellenlängen liegt und das im kurzwelligen Bereich hochtransparent ist.

2. Tandem-Dünnschicht-Solarzelle nach Anspruch 1,
**dadurch gekennzeichnet, dass**
zwischen der Frontzelle und der rückseitigen Zelle und/oder der Frontzelle und der Frontelektrode, mindestens eine Transportschicht angeordnet ist.

3. Tandem-Dünnschicht-Solarzelle nach Anspruch 1,
**dadurch gekennzeichnet, dass**
zwischen der Frontzelle und der rückseitigen Zelle und/oder der Frontzelle und der Frontelektrode, mindestens eine Fensterschicht angeordnet ist.

4. Tandem-Dünnschicht-Solarzelle nach Anspruch 3,
**dadurch gekennzeichnet, dass**
zwischen dem anorganischen Absorbermaterial der rückseitigen Zelle und der benachbart angeordneten Fensterschicht eine Pufferschicht angeordnet ist.

5. Tandem-Dünnschicht-Solarzelle nach Anspruch 1,
**dadurch gekennzeichnet, dass**
auf der der Frontzelle abgewandten Seite der Frontelektrode ein Kontaktgitter angeordnet ist.

6. Tandem-Dünnschicht-Solarzelle nach Anspruch 1,
**dadurch gekennzeichnet, dass**
zwischen der Frontzelle und der rückseitigen Zelle eine Rekombinationsschicht angeordnet ist.

7. Tandem-Dünnschicht-Solarzelle nach den Ansprüchen 2 bis 5, **dadurch gekennzeichnet, dass**
- die rückseitige Elektrode als Anode aus einer 500 nm bis 1000 nm dicken Molybdänschicht gebildet ist,
- die Frontelektrode als Kathode aus einer Mg:Ag-Schicht mit einer Schichtdicke kleiner als 10 nm und einer darauf angeordneten ZnO:Al-Schicht mit einer Schichtdicke von 50 nm bis 300 nm gebildet ist,
- die Frontzelle eine Schichtfolge des organischen Absorbermaterials aufweist, die frontseitig nach rückseitig aus
- einer C₆₀-Schicht mit einer Dicke von 3 nm bis 40 nm,
- einer Zn₃5Pc:C₆₀-Schicht mit einer Dicke von 50 nm bis 150 nm und
- einer Zn₃5Pc-Schicht mit einer Dicke von 2 nm bis 10 nm gebildet ist, und
- einer rückseitigen Zelle, die als anorganisches Absorbermaterial CuGaSe₂ und eine Schichtdicke von 1 µm bis 2,5 µm aufweist, und
- zwischen der organischen Schichtfolge des Absorbermaterials der Frontzelle und dem anorganischen Absorbermaterial der rückseitigen Zelle eine Schichtfolge, frontseitig nach rückseitig, angeordnet und gebildet ist aus
- einer MoO₃-Transportschicht mit einer Dicke von 3 nm bis 10 nm,
- einer ZnO:Al-Fensterschicht mit einer Dicke von 10 nm bis 200 nm,
- einer i-ZnO-Fensterschicht mit einer Dicke von 30 nm bis 100 nm und
- einer CdS-Pufferschicht mit einer Dicke von 10 nm bis 50 nm.
